# EUROPEAN PATENT SPECIFICATION

(11) **EP 1 755 125 B1**
(45) Date of publication and mention of the grant of the patent: **03.03.2010**
(21) Application number: 05017790.6
(22) Date of filing: 16.08.2005
(51) Int. Cl.: G11C 16/02

(54) **Method for operating a programmable metallization cell and electrical circuit**
Betriebsverfahren für eine programmierbare Metallisierungs-Speicherzelle und Schaltkreis
Méthode d'opération d'une cellule mémoire métallisé et circuit électrique

(43) Date of publication of application: 21.02.2007
(73) Proprietor: Qimonda AG, 81739 München (DE)
(72) Inventor: Röhr, Thomas, 85609 Aschheim (DE)
(74) Representative: Patentanwaltskanzlei WILHELM & BECK

(56) References cited:
- WO-A-2004/084229
- WO-A-2005/022548
- US-A- 5 761 115
- US-A1- 2003 209 971
- US-B1- 6 363 002

## Description

### Background of the invention

### 1. Field of the invention

The present invention refers to a method for operating a programmable metallization cell of a conductive-bridging random access memory, particularly for use in a CBRAM memory circuit.

### 2. Description of the related art

Memory cells comprising a solid electrolyte material are well known as PMC (programmable metallization cell) memory cells. Memory devices including such PMC memory cells are known as CBRAM (conductive-bridging random access memory) devices. The storing of different states in a PMC memory cell is based on the developing or diminishing of a conductive path in the electrolyte material between electrodes based on an applied electrical field. Although the electrolyte material has a high resistance, the conductive path between electrodes has a low resistance. Thereby, the PMC memory cell can be set to different states depending on the resistance of the PMC memory element. Usually, both states of the PMC memory cell are sufficiently time-stable in such a way that data may permanently be stored.

A PMC memory cell is operated by applying a positive or a negative voltage to the solid electrolyte of the PMC memory element. In order to store data into the PMC memory cell, the PMC memory cell is brought to a programmed stated by applying a suitable programming voltage to the PMC memory cell which results in the development of the conductive path in the electrolyte material and therefore in the setting of a first state with low resistance. In order to store a second state in the PMC memory cell with high resistance, an erase voltage has to be supplied in such a manner that the resistance of the PMC memory cell changes back to a high resistance which refers to an erased state. To read out a PMC memory cell, a read voltage is applied that is lower than the programming voltage. With the read voltage, a current through the resistance of the PMC memory element is detected and associated to the respective low or high resistance state of the PMC memory cell.

US 6,865,117 B2 describes a programming circuit for a programmable microelectronic device, a system including the circuit and a method for forming the same. The circuit is configured to provide a reversible bias across the microelectronic device to perform erase and write functions. One configuration of the programming circuit includes one or more inputs and a complementary metal-oxide semiconductor circuit coupled to the programmable device. This design allows for writing and erasing of the programmable cell using a low and a high voltage input. Depending on the state that should be programmed into the PMC cell, a high voltage is applied to the anode and a low voltage is applied to the cathode or, respectively, a low voltage is applied to the anode and a high voltage is applied to the cathode of the PMC cell.

US 5,761,115 discloses a programmable metallization cell structure and method of making the metallization cell. A programmable metallization cell comprises a fast ion conductor such as a chalcogenide metal ion and a plurality of electrodes disposed at the surface of the fast ion conductor and spaced a set distance apart from each other. Preferably, the fast ion conductor comprises a chalcogenide with an anode and a cathode. When voltage is applied to the anode and the cathode, a non-volatile metal dendrite grows from the cathode along the surface of the fast ion conductor towards the anode. The growth rate of the dendrite is a function of the applied voltage and time. The growth of the dendrite may be stopped by removing the voltage and the dendrite may be retracted by reversing the voltage polarity at the anode and cathode. Changes in the length of the dendrite affect the resistance and capacitance of the PMC. The PMC may be incorporated into a varity of technologies such as memory devices, programmable resistors/capacitor devices, optical devices, sensors/capacitor devices. Electrodes additional to the cathode and the anode can be provided to serve as outputs or additional outputs of the devices insensing electrical characteristics which are dependent upon the extend of the dendrite.

US 2003/0209971 A1 describes a programmable structure, an array including the structure and a method of forming the same. A microelectronic programmable structure suitable for storing information, and array including the structure and methods of forming and programming the structure are disclosed. The programmable structure generally includes an ion conductor and a plurality of electrodes. Electrical properties of the structure may be altered by applying energy to the structure, and thus information may be stored using the structure.

WO 2004/084229 A1 wherein the preamble of claim 1 is based describes a programmable resistance memory device. The programmable resistance memory device includes a semiconductor substrate, at least one cell array in which memory cells are arranged, formed above the semiconductor substrate, each the memory cell having a stack structure of a programmable resistance element and an access element, the programmable resistance element storing a high resistance state or a low resistance state determined due to the polarity of voltage application in a non-volatile manner. The access element having such a resistance value in an off-state in a certain voltage range that is ten times or more as high as that in a select state. A read/write circuit is formed in the semiconductor substrate as underlying the cell array for data reading and data writing in communication with cell array. Each memory cell is a series connection circuit of a programmable resistance and a Zener diode. The programmable resistance is a resistance film with an ion conductor formed of a chalcogenide containing metal ions.

### Summary of the invention

The object of the present invention is to provide a method for operating a programmable metallization cell of a conductive-bridging random access memory by which the programming operation is enhanced.

This object is achieved by a method for operating a programmable metallization cell according to claim 1.

Preferred embodiments of the present invention are defined in the dependent claims.

The present invention is a method for operating a programmable metallization cell of a conductive bridging random access memory (CBRAM). The CBRAM memory comprises plate lines, bit lines and memory cells. Each memory cell comprises a programmable metallization cell (PMC) and a switch, whereby a memory cell is arranged between a bit line and a plate line. Resistance values of the memory cells are programmable by applying different voltages to the PMC cells by changing the voltage value on the bit line, whereby the voltage on the plate line is changed with respect to the voltage of the bit line for increasing a voltage drop over the PMC cell to assist the programming of the PMC cell.

The present invention is based on the idea of providing a method for operating a programmable metallization cell which uses available voltage levels of a circuit or device more efficiently. This object is achieved by connecting the memory cells to a plate line and by changing the voltage on the plate line during an erasing or a programming operation. The voltage on the plate line is changed to a different direction compared to the voltage on the bit line. This has the advantage that two electrical potentials with small difference could be used for programming the PMC cell.

The idea of changing the voltage on the plate line could be used in any electrical circuit that comprises a PMC cell with a solid electrolyte which is adapted to selectively develop or diminish a conductive path depending on the applied electrical field. Particularly, this idea can be advantageously used in a CBRAM memory circuit providing a simple design that uses two electric potentials of the CBRAM memory circuit which are available on the CBRAM memory and have a small difference for programming and erasing the PMC cell.

### Brief description of the drawings

These and other objects and features of the present invention will become clear from the following description taken in conjunction with the accompanying drawings in which:
Figure 1 is a schematic view of a conductive-bridging junction of a PMC cell;
Figure 2 shows a diagram of the current depending on the voltage drop over the PMC cell for a program, read and erase state;
Figure 3 depicts a part of a CBRAM memory;
Figure 4 shows a diagram for a writing, an erasing and a reading operation; and
Figure 5 depicts a diagram for a signal sequence for a writing, an erasing and a reading operation of two PMC cells during one cycle.

### Description of the preferred embodiments

The present invention may be described in terms of various functional components. It should be appreciated that such functional components may be realized by any number of hardware or structural components configured to perform the specified functions. For example, the present invention may employ various integrated components comprised of various electrical devices, e.g. resistors, transistors, capacitors, diodes and such like, the values of which may be suitably configured for various intended purposes. In addition, the present invention may be practiced in any integrated circuit application where an effective reversible polarity is desired. Such general applications which may be appreciated by those skilled in the art in light of the present disclosure are not described in detail. Further, it should be noted that while various components may be suitably coupled or connected to other components within exemplary circuits, such connections and couplings can be realized by direct connection between components and by connection through other components and devices located in between.

The present invention generally relates to a method for operating a programmable metallization cell of a conductive bridging random access memory.

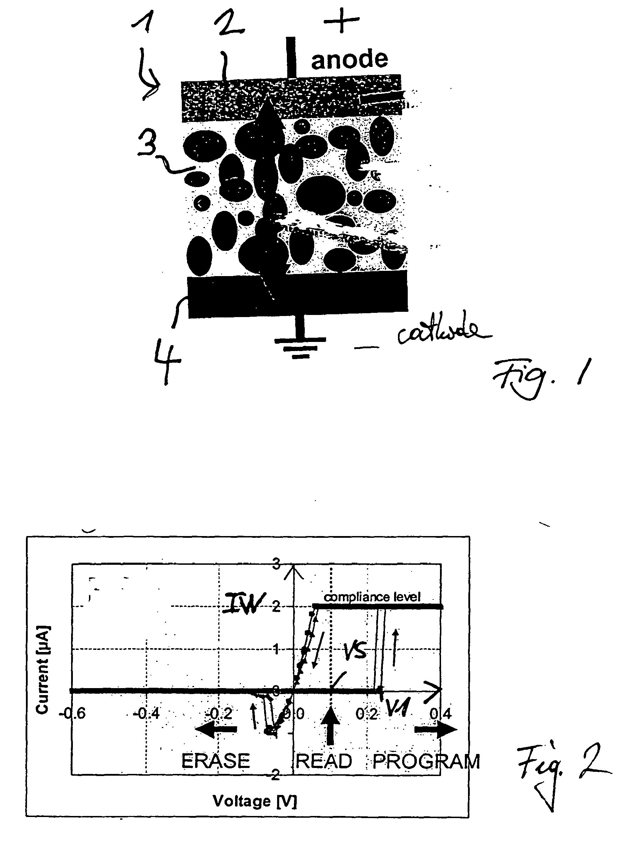

In a schematic view, Figure 1 depicts a conductive bridging junction of a PMC cell 1 comprising an anode 2, a cathode 4 and an electrolyte layer 3 in between. The cathode 4 is connected to a ground potential and the anode 2 may be connected to a high potential in the depicted situation that shows a programming operation.

The structure shown in Figure 1 may be used in order to store information and thus may be used in memory circuits. For example, the conductive bridging junction or other programmable structure in accordance with the present invention may be suitably used in memory devices to replace DRAM, SRAM, PROM, EEPROM, flash devices or any combination of such memories. In addition, programmable structures of the present invention may be used for other applications where programming or changing of electrical properties of a portion of an electrical circuit are desired.

The electrolyte layer 3 is formed by material which conducts ions upon application of a sufficient voltage. Suitable materials for ion conductors include polymers, glasses and semiconductor materials. In one exemplary embodiment of the invention, the electrolyte layer 3 is formed by chalcogenides material. The electrolyte layer 3 may also suitably include dissolved and/or dispersed conductive material. For example, the electrolyte layer 3 may comprise a solid solution that includes dissolved metals and/or metal ions. The chalcogenides materials including silver, copper, combinations of these materials and such like could be used for constituting the electrolyte layer 3.

The anode 2 and the cathode 4 may be formed by any suitable conductive material. For example, the anode 2 and the cathode 4 may be formed by doped polysilicon material or metal. In accordance with one exemplary embodiment of the present invention, one of the electrodes, i.e. the anode 2, is formed by a material including a metal which dissolves in ion conductors when a sufficient bias is applied across the electrodes and the other electrode, i.e. the cathode is relatively inert and does not dissolve during operating of the programmable device. The first electrode 2 may be an anode during a write operation and be comprised of a material including silver which dissolves in the electrolyte layer. The second electrode 4 may be a cathode during the write operation and be comprised of an inert material such as tungsten, nickel, molybdenum, platinum, metal silicides, and such like.

The conductive bridging junction is configured in such a way that when a bias larger than a threshold voltage is applied across the electrodes 2, 4, the electrical properties of the electrolyte layer 3 change. If a voltage is applied larger than the threshold voltage, conductive ions within the electrolyte layer start to migrate and to form a region having an increased conductivity compared to the conductor at or near the more negative of the electrodes 2, 4. As the conductive region forms, the resistance between the electrodes 2, 4 decreases and other electrical properties may also change. If the same voltage is applied in reverse, the conductive region will dissolve back into the electrolyte layer and the device will return to a high resistance or erased state.

The basic reaction is if a higher voltage is applied at the anode 2, a redox reaction at the cathode 4 drives metal ions from the reactive anode into the electrolyte layer 3. Therefore, in the electrolyte layer 3, metal-rich clusters are formed. The result is a conductive bridge that occurs between the anode and the cathode. If a reverse voltage is applied to the PMC cell 1, the metal-rich clusters are dissolved and the conductive bridge is degraded.

Figure 2 shows a diagram of the voltage and the current occurring during a programming operation, a read operation and an erase operation of a PMC cell 1. At the start, the PMC cell is not programmed and therefore has a high resistance. If a voltage is applied with a higher voltage at the anode 2 and a lower voltage at the cathode 4, no current flows through the PMC cell 1 until a threshold voltage V1 is applied. With the voltage rising over the threshold voltage V1, current starts to flow until a working current IW is achieved which is confined by the programming circuit. The voltage is then reduced to 0 Volt, whereby the current falls to 0 A. Now the PMC cell is programmed.

If the program status is to be sensed or read, a sensing voltage is applied to the PMC cell which is lower than the threshold voltage V1. The sensing voltage VS may be about 0.1 Volt. Due to the sensing voltage, a working current IW flows through the PMC cell. Without the programming operation, no current would flow through the PMC cell applied to a sensing voltage. To erase the program status, a lower voltage, i.e. a negative voltage is applied to the anode 2 starting at 0 Volt. Up to a negative voltage of about -0.1 Volt, a negative current flows through the PMC cell 1, but when the negative voltage drops over - 0.1 Volt, the current goes down to 0 A. Now the PMC cell 1 again has the same high resistance as prior to the programming operation.

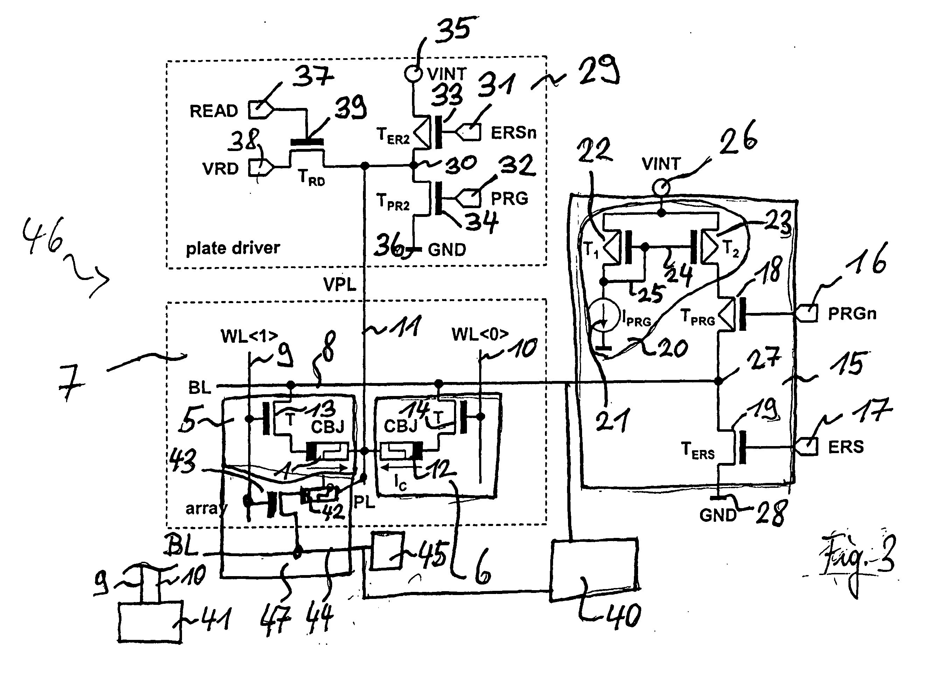

Figure 3 depicts parts of an electrical circuit 46 i.e. a CBRAM comprising memory cells 5, 6, 47 with PMC cells 1, 12, 42 that are connected to a common plate line 11. The plate line 11 constitutes a conductive line or area that is connected with many PMC cells 1, 12, 42. Furthermore, the memory cells 5, 6, 47 are connected to first lines 8, 44 with a writing unit 15, 45 and with second lines 9, 10 with a controlling unit 41. The plate line 11 is connected to a voltage unit 29. Furthermore, a sensing unit 40 is connected to the first and further first line 8, 44.

In a simple embodiment, two memory cells 5, 6 are arranged which comprise a first and a second PMC cell 1, 12, the anodes of which are connected to a first and second switch 13, 14. The first and the second switch 13, 14 are connected to the first line 8. Furthermore, controlling inputs of the first and the second switch 13, 14 are connected to a second line 9 and to a further second line 10, respectively.

The writing unit 15 comprises a first input 16 and a second input 17. The first input 16 is a programming input and the second input 17 is an erasing input. Furthermore, the writing unit 15 comprises a voltage source with different potentials 26, 28. Depending on the signals on the first input 16 and the second input 17, a high or a low voltage 28, 26 is applied to the first line 8. Furthermore, the writing unit 15 preferably comprises a current source 21. The current source 21 confines the maximum current which flows from the writing unit 15 to the first line 8 during a programming operation. The sensing unit 40 is connected to the first line 8 and is configured to detect a current on the first line 8.

A voltage unit 29 is disposed that comprises in a first embodiment a third input 31 and a fourth input 32. The third input 31 is disposed for controlling an erasing operation and the fourth input 32 is disposed for controlling a programming operation. Furthermore, the voltage unit 29 comprises a voltage source 35, 36 with different potentials. The voltage unit 29 applies different voltages to the plate line 11 depending on the input signals on the third input 31 and the fourth input 32. For example, if a programming operation is performed, the controlling unit 41 selects one of the second or further second lines 9, 10 and applies a high voltage to a selected second line 9. According to the high voltage on the second line 9, the first switch 13 is closed providing a conductive connection between the anode 2 of the first PMC cell 1 and the first line 8. Additionally, a programming signal is put on the first input 16 of the writing unit 15. According to the programming signal, the writing unit 15 applies a high voltage of about 3.4 Volt on the first line 8. Furthermore, the further program signal is put on the fourth input 32 of the voltage unit 29. According to this program signal, the voltage unit 29 applies a low voltage to the plate line 11. For example, the low voltage is about 0 Volt, i.e. ground potential, but certainly lower than the high voltage that is applied by the writing unit 15 on the first line 8. This results in a bias voltage over the PMC cell 1 which has a voltage difference between the low voltage of the voltage unit 29 on the plate line 11 and the high voltage of the writing unit 15 on the first line 8.

During the programming operation, the resistance of the first PMC cell is changed from a high resistance to a low resistance as explained in accordance with Figure 2. After the programming, the controlling unit 41 changes the voltage on the second line 9 to a low voltage opening the first switch 13. Furthermore, the further program signal is stopped at the first input 16 and therefore, the writing unit 15 stops to apply a high voltage to the second line 8. Additionally, the program signal is stopped on the fourth input 32 and therefore, the voltage unit 29 stops to apply the low voltage to the plate line 11.

If the state of the first PMC cell 1 is to be changed from low resistance to high resistance, an erasing operation is carried out. For erasing the state of the first PMC cell 1, the controlling unit 41 selects the second line 9 and applies a high voltage on the second line 9. The high voltage on the second line 9 closes the first switch 13 connecting the anode 2 of the first PMC cell 1 with the second line 8. Additionally, an erasing signal is put on the second input 17. According to the erasing signal on the second input 17, the writing unit 15 applies a low voltage to the second line 8. Accordingly, a further erasing signal is put on the third input 31 causing the voltage unit 29 to apply a high voltage to the plate line 11. Therefore, a negative voltage is applied to the electrolyte layer 3 higher than the erasing voltage. As a result, the conductive bridging is dissolved and the PMC cell 1 acquires a high resistance again. To end the erasing operation, the erasing signal is stopped on the second input 17. Thus, the write unit 15 stops applying a low voltage to the second line 8. Furthermore, the further erasing signal is stopped on the third input 31 of the voltage unit 29. Consequently, the voltage unit 29 stops to apply a high voltage to the plate line 11. Furthermore, the controlling unit 41 stops to apply a high voltage on the first word line 9. This results in opening the first switch 13 disconnecting the first PMC cell 1 from the first line 8.

In a further embodiment, the voltage unit 29 comprises a fifth input 37 for a read signal. Furthermore, the voltage unit 29 comprises a read voltage source 38. If the state of the first PMC cell 1 is to be sensed, the controlling unit 41 applies a voltage to the second line 9, closing the first switch 13. Furthermore, a read signal is put on the fifth input 37 of the voltage unit 29. This causes the voltage unit 29 to connect the plate line 11 to the read voltage source 38. The read voltage source 38 applies a read voltage on the plate line 11. Furthermore, the sensing unit 40 is connected to the first line 8 applying a respective potential on the first bit line 8 to generate a read voltage drop in the electrolyte layer 3. The read voltage drop is about 0.1 Volt. Depending on the state of the PMC cell 1, the sensing unit 40 detects no current over the PMC cell 1 if the first PMC cell 1 is in a high resistance state. If the first PMC cell 1 is in a low resistive state, the sensing unit 40 detects a working current IW over the first PMC cell 1. Therefore, the sensing unit 40 is able to check whether the first PMC cell 1 is in a low or in a high resistive state. Thus, the first PMC cell 1 can be used to store a data, e.g. the data "0" for a low resistive state and the data "1" for a high resistive state which can be checked by the sensing unit 40.

In a simple embodiment, the writing unit 15 comprises a high potential contact 26 and a low potential contact 28. The low potential contact 28 may be connected to ground potential and the high potential contact 26 may be connected to an internal high potential of the electrical circuit 47. The high potential contact 26 is additionally connected to a current mirror 20 with the current source 21 which induces the current of the current source 21 on a second branch that connects the high potential contact 26 with a third switch 18. A controlling contact of the third switch 18 is connected with the first input 16. An output of the third switch 18 is connected to a connecting point 27.

The low potential contact 28 is connected to an input of a fourth switch 19, the output of which is connected to the connecting point 27. A controlling contact of the fourth switch 19 is connected to the second input 17. The connecting point 27 is connected with the first line 8.

Preferably, the fourth switch 19 is constituted as an n-channel field effect transistor and the third switch 18 is constituted as a p-channel field effect transistor 18. If a low voltage is applied to the controlling contact of the third switch 18, the third switch 18 is switched into a current state. Furthermore, if a high voltage is applied to the second input 17, the fourth switch 19 is closed, connecting the connecting point 27 to the low potential contact 28.

The current mirror 20 comprises a first transistor 22 in series with the current source 21 which is connected to a ground potential. An input of the first transistor 22 is connected to the high potential contact 27. Furthermore, a second transistor 23 is arranged in between the high potential contact 26 and the third switch 18. The first and the second transistor 22, 23 are realized as p-channel field effect transistors. The gates of the first and the second transistor 22, 23 are connected by a connecting line 24. The connecting line 24 is connected by a second connecting line 25 with an input of the current source 21 that is connected to the first transistor 22. The current source 21 confines the maximum current flowing through the closed third switch 18 during a program operation. This helps to avoid a destruction of the PMC cells 1, 12.

In a further embodiment, the voltage unit 29 comprises a second high potential contact 35 that is connected with a high voltage source and a second low potential contact 36 which is connected with a low voltage source, e.g. with ground potential. Between the second high potential contact 25 and the second low potential contact 36, a third transistor 33 and a fourth transistor 34 are arranged in series. Between the third and the fourth transistor 33, 34, a second connecting point 30 is arranged connected to the plate line 11. The third transistor 33 is realized as a p-channel field effect transistor and the fourth transistor 34 is realized as an n-channel field effect transistor. A gate contact of the third transistor 33 is connected to the third input 31. A gate contact of the fourth transistor 34 is connected to the fourth input 32.

Furthermore, a fifth transistor 39 realized as an n-channel field effect transistor is disposed between the read voltage source 38 and the plate line 11. A gate contact of the fifth transistor 39 is connected to the fifth input 37.

The program operation, the reading operation and the erasing operation that was explained above regarding the first PMC cell 1 is the same with the second PMC cell 12 whereby instead of the second line 9 the further second line 10 has to be activated by the controlling unit 41 closing the second switch 14. The other operation steps are the same.

Depending on the electronic device in which the PMC cells are disposed, e.g. in case of a CBRAM memory device, the first line 8 constitutes a first bit line and the second line 9 constitutes a first word line and the further second line 10 constitutes a second word line. Furthermore, in a memory a large array 7 with a lot of PMC cells is disposed whereby the PMC cells of the array are connected by the cathodes to a common plate line 11. In the case of a CBRAM, a lot of bit lines and a lot of word lines are arranged in a crossed net structure, whereby at the crossing points of a bit and a word line memory cell 5, 6 are arranged. If there are a lot of bit lines 8, for each bit line a writing unit 15 may be provided or a common writing unit 15 is used which is connected to selected bit lines by a multiplexer unit.

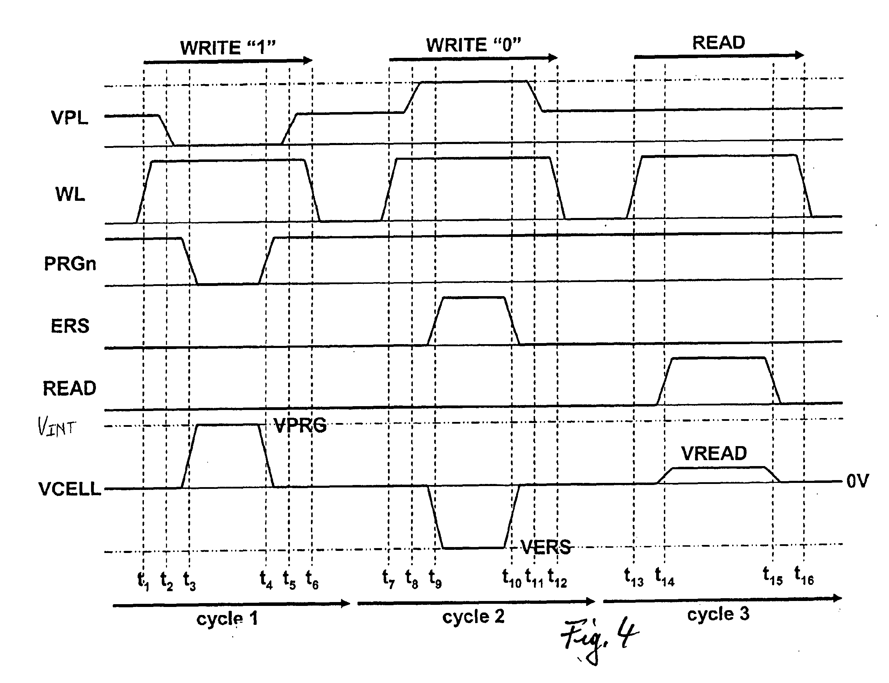

In a first time line, Figure 4 shows a plate voltage VPL of the plate line 11, in a second time line, a word voltage WL of a second line, in a third time line, a program signal PRG on a first input 16, in a fourth time line, an erase signal ERS on the second input 17, in a fifth time line, a read signal READ on the fifth input 37, and in a sixth time line a voltage drop VCELL of the first PMC cell 1 over the time axis.

A first programming cycle used to write e.g. the data "1" into a non-programmed first PMC cell 1 starts shortly before a first point of time t₁ by rising the word voltage WL on first line 9. In a following step, the plate voltage VPL of the plate line 11 is changed from a medium value to a low value by applying a high voltage on the fourth input 32 closing the fourth transistor 34. The fourth transistor 34 connects the plate line 11 which has a medium level of voltage with ground potential. The medium value of the voltage of the plate line 11 may be half of an internal voltage VINT of the electrical circuit. The low voltage of the plate line 11 is reached shortly after a second point of time t₂. When the plate voltage reaches the low level, the program signal PRG is put on the first input 16 and the voltage on the gate of the third switch 18 is lowered to 0 Volt. This turns the third switch 18 into a current state applying a high voltage on the first line 8. Furthermore, the first switch 13 is in a current state, as well, according to the high voltage on the second line 9. On the cathode of the first PMC cell 1, the low voltage of 0 Volt is applied and the anode 2 of the first PMC cell 1 is connected to the high voltage of the high potential contact 26. Thus, a voltage drop VCELL over the first PMC cell 1 rises between a third and a fourth point of time t₃, t₄, over the threshold voltage V1. The voltage drop approximately has the value of the internal voltage VINT of the high potential contact 26. As explained above, a voltage drop VCELL over the threshold changes the resistance in the electrolyte layer 3. After a predetermined time, the program signal PRG on the first input 16 is raised from the low voltage to the high voltage opening the third switch 18. The plate voltage on the plate line 11 is subsequently raised to a medium level. As a result, the voltage drop VCELL over the PMC cell 1 drops to 0 Volt. Finally, the word voltage WL on the second line 9 is reduced to 0 Volt. Thus, after the sixth point of time t₆, the programming operation of the PMC cell 1 is finished.

In a following second cycle, the programming of the PMC cell 1 is erased that means that the data 0 is stored in the PMC cell 1. The second cycle is started raising the word voltage WL on the second line 9 shortly before a seventh point of time t₇. Then the potential of the plate line 11 is raised from the medium value to a high value. After reaching the high value on the plate line 11, an erasing signal ERS is put on the second input 17. The erasing signal increases the voltage on the gate contact of the fourth switch 19. Thus, the fourth switch 19 is switched into a current state connecting the low potential contact 28 to the first line 8. This causes a voltage drop VCELL across the PMC cell 1 starting shortly before the ninth point of time t₉ and achieving a negative maximum voltage shortly after the ninth point of time t₉. The negative voltage drop VCELL across the electrolyte layer 3 dissolves the conductive bridging connection between the anode 2 and the cathode 4, changing the resistance of the PMC cell 1 as explained above.

After a given time, the erasing signal ERS on the second input 17 is lowered to 0 Volt. This causes a fall of the voltage drop VCELL across the PMC cell 1. Furthermore, the potential of the plate line 11 is reduced after a tenth point of time t₁₀ from the high state to a medium value. Finally, the word voltage WL of the second line 9 is lowered to a low voltage. The time during which the voltage drop VCELL is applied to the electrolyte layer 3 of the PMC cell 1 lasts as long as it is necessary to dissolve the conductive connection between the two electrodes of the PMC cell 1. After the second cycle, the PMC cell 1 has the same high resistance as prior to the first cycle 1. During the first cycle and during the second cycle, the potential of the plate line 11 is changed in a contrary direction compared to the potential of the first line 8. Therefore, available potential sources, e.g. a ground voltage and a high voltage of a device, may preferably be used for achieving a high voltage drop during an erasing and a programming operation of the PMC cell and additionally provide a medium voltage on the plate line 11 during other periods of time.

In a third cycle, the programming state of the PMC cell 1 is sensed. The sensing operation starts with a rising potential on the second line 9 shortly before a thirteenth point of time t₁₃ up to a high level. A read signal READ is applied to the fifth input 37 connecting the read voltage source 38 to the plate line 11. The voltage of the read voltage source 38 is lower than the threshold voltage V1 necessary to program the PMC cell 1. Thus, the sensing unit 40 detects a voltage drop VREAD determined by the third voltage source 38 and a current depending on the program state of the PMC cell. In our embodiment, the PMC cell 1 has been erased before the reading operation, therefore unit 40 senses no current during the read status. After sensing the current through the PMC cell 1, the read signal READ is put to 0 Volt and the potential on the second line 9 is put to 0 Volt, as well. This causes the voltage drop VCELL to fall from a high level VREAD to a 0 level.

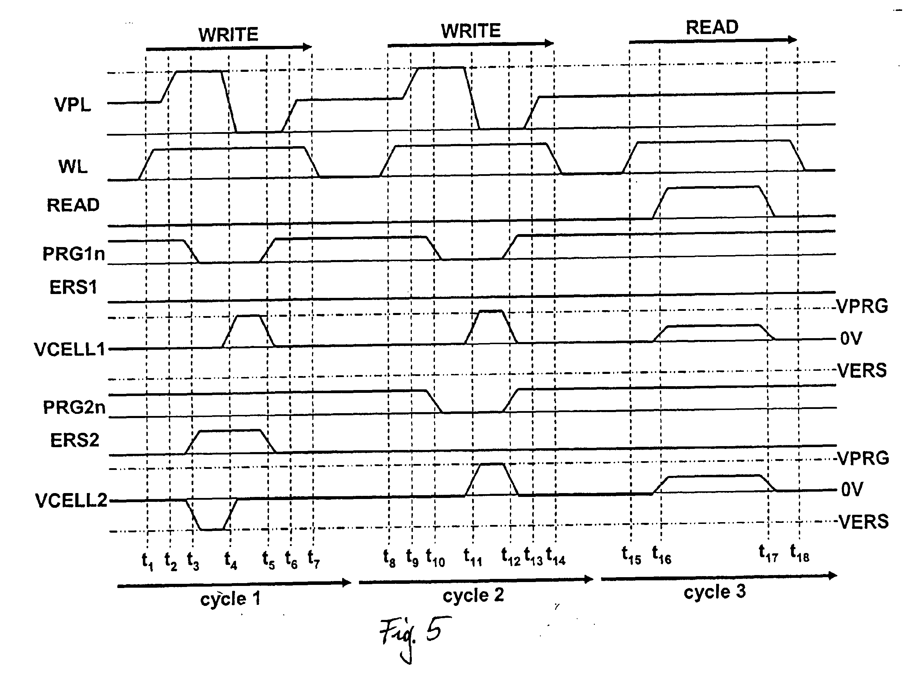

Figure 5 shows a time-dependent diagram of the plate potential VPL of the plate line 11, the word potential of a second line 9, a read signal READ which is applied to the fifth input 37 of the voltage unit 29, a first programming signal PRG1n that is applied to a first input 16 of the writing unit 15, a first erasing signal ERS1 which is applied to a second input 17 of the writing unit 15, a voltage drop VCELL1 across the first PMC cell 1, a second programming signal PRG2n of a second writing unit 15, which is applied to a corresponding input of the further writing unit 45, a second erasing signal ERS2 which is put on a corresponding second input of the second writing unit 45 and a second voltage drop VCELL2 across the third PMC cell 42.

Figure 5 depicts a further method for writing, erasing and reading data for different PMC cells 1, 42. For this method, two PMC cells 1, 42 are connected with respective switches 13, 43 comprising one common second line 9, e.g. a word line. The bit lines 8, 44 of the first and third PMC cells 1, 42 are connected to a common writing unit or respective writing units 15, 45. In the shown embodiment, the third PMC cell 42 is connected by a fifth switch 43 to the further first line 44 that is connected with a further writing unit 45. The structure of the further writing unit 45 is identical to the writing unit 15. At the start, the word voltage WL of the common second line 9 is raised from a low level to a high level at a first point of time t₁. In a further step, the plate potential VPL of the plate line 11 is raised from a medium value to a high value starting shortly before a second point of time t₂. The high level is maintained until a fourth point of time t₄ is reached. Shortly before the fourth point of time t₄, the plate potential VPL of the plate line 11 is changed from the high value to a low level which is e.g. the mass potential and is lower than the medium value. The low level is kept on the plate line 11 until a sixth point of time t₆. Shortly before the sixth point of time t₆, the potential of the plate line 11 is raised to the medium value.

During the writing operation, the word voltage WL of the second line 9 is maintained at the high value shortly before a seventh point of time t₇ and then lowered to the low level. The high voltage on the second line 9 results in closed switches 13, 43 which connect the first PMC cell 1 and the third PMC cell 42 to respective first and third lines 8, 44 representing bit lines.

Shortly before the third point of time t₃, the program signal on the first input 16 is lowered from a high value to a low value. At the same time, a further erasing signal ERS2 of the further writing unit 45 is raised from a low value to a high value. The high value on the erasing input of the further writing unit connects the third line 44 of the further first PMC cell 42 to a low voltage. Additionally, the plate line 11 that is connected to a cathode of the third PMC cell 42 is on a high level. This results in a voltage drop VCELL2 on the third PMC cell 42 which is higher than the threshold erasing voltage. Thus, the third PMC cell 42 is applied to an erasing voltage between the third point of time t₃ and the fourth point of time t₄.

The resistive state of the third PMC cell 42 is erased between the third and the fourth point of time t₃, t₄. Thus, a date "0" is programmed in the third PMC cell. Due to the change of the potential of the plate line 11 around the fourth point of time t₄, the voltage drop VCELL2 along the third PMC cell 42 falls to 0 Volt shortly after the fourth point of time t₄. Shortly before the fourth point of time t₄, a voltage drop VCELL1 along the first PMC cell 1 rises from 0 Volt up to a high level. The high level voltage is maintained until shortly before the fifth point of time t₅ and falls back to the 0 voltage. Between the fourth and the fifth point of time t₄, t₅, the resistive state of the first PMC cell 1 is changed to a low resistance and therefore the first PMC cell is programmed to date "1".

The advantage of this programming method is that memory cells may be programmed with different data at the same time. In the explained example, the first PMC cell 1 is programmed with a low resistance corresponding to data "1" and the third PMC cell 42 is programmed with a high resistance corresponding to data "0". This is shown in cycle 1 of Figure 5.

During a second cycle 2 of Figure 5, a low resistance is programmed in the first PMC cell 1 and a low resistance is programmed in the third PMC cell 42. During this program step, the plate potential VPL of the plate line 11 is firstly raised from the medium level up to a high level during a first time period and secondly lowered to a ground level during a second time period and finally raised to the medium level. This is the same procedure as in the first cycle 1. The word potential WL of the second line 9 is also raised during the whole cycle from a basic level to a high level and subsequently returned to the basic level. The first program signal PRG1n is lowered from the high level to the low level during the first time period in which the plate potential VPL is at a high level and at a low level during the second time period in which the plate line is on a low level. During the first time period, the plate potential is high and the voltage on the first line 8 is high. Thus, no programming of the first PMC cell 1 occurs. During the second time period, this results in a high first voltage drop VCELL1 across the first PMC cell. During this period of time, the first PMC cell is programmed to low resistance.

In contrast to the first cycle 1, the second program signal PRG2n is lowered from a high level during the second cycle 2 in the same time as the first program signal PRG1n to a low level and then raised to a high level again. The lowering of the second program signal PRG2n results in connecting the further bit line with high potential. This occurs during the second time period which is between an eleventh point of time t₁₁ and a twelfth point of time t₁₂ in a positive and high second voltage drop VCELL2 which results in a programming of the third PMC cell 42 with a low resistance. This shows that using a cycle with a rising and a dropping voltage on the plate line 11 and different potentials on different first lines 8, 44 during a cycle, the PMC cells 1, 42 connected to a common second line, e.g. a common word line and a common plate line 11, may be programmed with different resistance values and thus with different data during one cycle.

In a following third cycle of Figure 5, a reading operation is shown for two PMC cells 1, 42 which are connected to the same plate line 11 and are connected to the same second line 9. Furthermore, the two PMC cells 1, 42 are connected with two different first lines 8, 44 and the two different first lines are each connected to the sensing unit 40. During the reading operation, the plate voltage VPL on the plate line is kept constant, the voltage on the second line 9 is raised to close the respective switches 13, 43 of the two memory cells 5, 47 to connect the respective PMC cells 1, 42 to respective first lines 8, 44. Furthermore, the read signal READ is applied to the fifth input 37 of the voltage unit 29. According to the read signal, the fifth transistor 39 is closed connecting the plate line 11 to the read voltage source 38 applying a read voltage to the cathodes of the PMC cells 1, 42 which are connected to the plate line 11. The first lines 8, 44 of the two memory cells are held at a potential which results in a voltage drop on the two PMC cells 1, 42, the voltage drop being in a range lower than the threshold voltage. This is shown in Figure 5 with the first voltage drop VCELL1 and the second voltage drop VCELL2. The sensing signals that are measured by the sensing unit 40 are not shown in the diagram. Previously, the two PMC cells 1, 42 were programmed in the second cycle to a low resistance level. Thus, on the two first lines 8, 44 of the two memory cells 5, 47 the sensing unit 40 detects a small current corresponding to the low resistive state of the PMC cells.

### Reference list

- 1: first PMC cell
- 2: first electrode
- 3: electrolyte layer
- 4: second electrode
- 5: memory cell
- 6: second memory cell
- 7: array of memory cells
- 8: first line
- 9: second line
- 10: further second line
- 11: plate line
- 12: second PMC cell
- 13: first switch
- 14: second switch
- 15: writing unit
- 16: first input
- 17: second input
- 18: third switch
- 19: fourth switch
- 20: current mirror
- 21: current source
- 22: first transistor
- 23: second transistor
- 24: connecting line
- 25: second connecting line
- 26: high potential contact
- 27: connecting point
- 28: low potential contact
- 29: voltage unit
- 30: second connecting point
- 31: third input
- 32: fourth input
- 33: third transistor
- 34: fourth transistor
- 35: second high potential contact
- 36: second low potential contact
- 37: fifth input
- 38: read voltage source
- 39: fifth transistor
- 40: sensing unit
- 41: controlling unit
- 42: third PMC cell
- 43: fifth switch
- 44: further first line
- 45: further writing unit
- 46: electric circuit
- 47: third memory cell
- VPL: plate voltage
- WL: word voltage
- PRG: program signal
- READ: read signal
- ERS: erase signal
- VCELL: voltage drop

## Claims

1. Method for operating a programmable metallization cell (PMC) (1, 12, 42) of a conductive bridging random access memory (46), whereby the CBRAM memory (46) comprises plate lines (11), bit lines (8, 44) and PMC memory cells (5, 6, 47), each memory cell (5, 6, 47) comprises a programmable metallization cell (PMC) (1, 12, 42), whereby a memory cell (5, 6, 47) is arranged between a bit line (8, 44) and a plate line (11), whereby resistance values of the PMC memory cells (5, 6, 47) are programmable by applying different voltages to the PMC memory cells (5, 6, 47) by changing the voltage value on the bit line (8, 44), whereby the voltage on the plate line (11) is changed with respect to the voltage of the bit line (8, 44) for increasing a voltage drop over the PMC memory cell (1, 12, 42) to assist the programming of the PMC memory cell (5, 6, 47),
wherein the voltage on the plate line (11) is changed and then maintained from a starting level to a high level during a first time period (t2, t4) and the voltage is lowered and then maintained beneath the starting level to a first low level during a following second time period (t4, t5), wherein the voltage on a first bit line (8) is lowered and then maintained in the first time period to a second low level to program a first PMC memory cell (5) and the voltage on a second bit line (44) is arisen and then maintained to a second high level during the second time period to program a second PMC memory cell (47),
**characterized in that** during the first time period and during the second time period a word voltage (WL) has a high value defining a writing operation and connecting the first and second PMC memory cell to the respective first and second bit line (8, 44).

2. The method according to claim 1, wherein the voltage on the plate line (11) is changed from a starting level to a first low level during a first time period, then the voltage is arisen to a first high level during a second time period, the first high level being higher than the starting level, wherein the voltage on a first bit line (8) is arisen in the first time period to a second high level to program a first PMC memory cell (5) and the voltage on a second bit line (44) is lowered to a second low level during the second time period to program a second PMC memory cell (47).

3. The method of claim 1, wherein the voltage on the first bit line (8) is kept at the low level during the first and second time period and the voltage on the second bit line (44) is kept at the high level during the first and the second time period.

4. The method of claim 2, wherein the voltage on the first bit line (8) is kept at the high level during the first and the second time period and the voltage on the second bit line (44) is kept at the low level during the first and the second time period.

## Patentansprüche

1. Verfahren zum Betreiben einer programmierbaren Metallisierungszelle (PMC) (1, 12, 42) eines leitenden überbrückenden Direktzugriffspeichers (46), wobei der CBRAM-Speicher (46) Plattenleitungen (11), Bitleitungen (8, 44) und PMC-Speicherzellen (5, 6, 47) umfaßt, wobei jede Speicherzelle (5, 6, 47) eine programmierbare Metallisierungszelle (PMC) (1, 12, 42) umfaßt, wobei eine Speicherzelle (5, 6, 47) zwischen einer Bitleitung (8, 44) und einer Plattenleitung (11) angeordnet ist, wobei Widerstandswerte der PMC-Speicherzellen (5, 6, 47) durch Anlegen verschiedener Spannungen an die PMC-Speicherzellen (5, 6, 47) durch Ändern des Spannungswerts auf der Bitleitung (8, 44) programmiert werden können, wobei die Spannung auf der Plattenleitung (11) bezüglich der Spannung der Bitleitung (8, 44) zum Vergrößern eines Spannungsabfalls über der PMC-Speicherzelle (1, 12, 42) verändert wird, um das Programmieren der PMC-Speicherzelle (5, 6, 47) zu unterstützen,
wobei die Spannung auf der Plattenleitung (11) während einer ersten Zeitperiode (t2, t4) von einem Startpegel auf einen hohen Pegel verändert und dann aufrechterhalten wird und die Spannung während einer folgenden zweiten Zeitperiode (t4, t5) unter den Startpegel auf einen ersten niedrigen Pegel abgesenkt und dann aufrechterhalten wird, wobei die Spannung auf einer ersten Bitleitung (8) in der ersten Zeitperiode auf einen zweiten niedrigen Pegel abgesenkt und dann aufrechterhalten wird, um eine ersten PMC-Speicherzelle (5) zu programmieren, und die Spannung auf einer zweiten Bitleitung (44) während der zweiten Zeitperiode auf einen zweiten hohen Pegel angehoben und dann aufrechterhalten wird, um eine zweite PMC-Speicherzelle (47) zu programmieren,
**dadurch gekennzeichnet, daß** während der ersten Zeitperiode und während der zweiten Zeitperiode eine Wortspannung (WL) einen hohen Wert aufweist, der eine Schreiboperation definiert und die erste und zweite PMC-Speicherzelle mit der jeweiligen ersten und zweiten Bitleitung (8, 44) verbindet.

2. Verfahren nach Anspruch 1, wobei die Spannung auf der Plattenleitung (11) während einer ersten Zeitperiode von einem Startpegel auf einen ersten niedrigen Pegel verändert wird, die Spannung dann während einer zweiten Zeitperiode auf einen ersten hohen Pegel angehoben wird, wobei der erste hohe Pegel höher ist als der Startpegel, wobei die Spannung auf einer ersten Bitleitung (8) in der ersten Zeitperiode auf einen zweiten hohen Pegel angehoben wird, um eine erste PMC-Speicherzelle (5) zu programmieren, und die Spannung auf einer zweiten Bitleitung (44) während der zweiten Zeitperiode auf einen zweiten niedrigen Pegel abgesenkt wird, um eine zweite PMC-Speicherzelle (47) zu programmieren.

3. Verfahren nach Anspruch 1, wobei die Spannung auf der ersten Bitleitung (8) während der ersten und zweiten Zeitperiode auf dem niedrigen Pegel gehalten wird und die Spannung auf der zweiten Bitleitung (44) während der ersten und der zweiten Zeitperiode auf dem hohen Pegel gehalten wird.

4. Verfahren nach Anspruch 2, wobei die Spannung auf der ersten Bitleitung (8) während der ersten und der zweiten Zeitperiode auf dem hohen Pegel gehalten wird und die Spannung auf der zweiten Bitleitung (44) während der ersten und der zweiten Zeitperiode auf dem niedrigen Pegel gehalten wird.

## Revendications

1. Procédé de fonctionnement d'une cellule métallisée programmable (PMC) (1, 12, 42) d'une mémoire vive à passerelle conductrice (CBRAM) (46), la mémoire CBRAM (46) comprenant des lignes plaque (11), des lignes de bit (8, 44) et des cellules mémoire PMC (5, 6, 47), chaque cellule mémoire (5, 6, 47) comprenant une cellule métallisée programmable (PMC) (1, 12, 42), une cellule mémoire (5, 6, 47) étant agencée entre une ligne de bit (8, 44) et une ligne plaque (11), des valeurs de résistance des cellules mémoire PMC (5, 6, 47) étant programmables par application de tensions différentes aux cellules mémoire PMC (5, 6, 47) par modification de la valeur de tension sur la ligne de bit (8, 44), la tension sur la ligne plaque (11) étant modifiée relativement à la tension sur la ligne de bit (8, 44) pour accroître une chute de tension aux bornes de la cellule mémoire PMC (1, 12, 42) et faciliter ainsi la programmation de la cellule mémoire PMC (5, 6, 47),
la tension sur la ligne plaque (11) étant modifiée d'un niveau de départ à un niveau haut puis maintenue à celui-ci durant un premier intervalle de temps (t2, t4), et la tension étant abaissée sous le niveau de départ à un premier niveau bas puis maintenue à celui-ci durant un second intervalle de temps (t4, t5) suivant,
la tension sur une première ligne de bit (8) étant abaissée à un second niveau bas puis maintenue à celui-ci durant le premier intervalle de temps en vue de programmer une première cellule mémoire PMC (5) et la tension sur une seconde ligne de bit (44) étant portée à un second niveau haut puis maintenue à celui-ci durant le second intervalle de temps en vue de programmer une seconde cellule mémoire PMC (47),
le procédé étant **caractérisé en ce que**, durant le premier intervalle de temps et durant le second intervalle de temps, une tension de mot (WL) possède une valeur élevée définissant une opération d'écriture et connectant les première et seconde cellules mémoire PMC respectivement aux première et seconde lignes de bit (8, 44).

2. Procédé selon la revendication 1, la tension sur la ligne plaque (11) étant modifiée d'un niveau de départ à un premier niveau bas durant un premier intervalle de temps, puis portée à un premier niveau haut durant un second intervalle de temps, le premier niveau haut étant plus élevé que le niveau de départ,
la tension sur une première ligne de bit (8) étant portée à un second niveau haut durant le premier intervalle de temps en vue de programmer une première cellule mémoire PMC (5) et la tension sur une seconde ligne de bit (44) étant abaissée à un second niveau bas durant le second intervalle de temps en vue de programmer une seconde cellule mémoire PMC (47).

3. Procédé selon la revendication 1, la tension sur la première ligne de bit (8) étant maintenue au niveau bas durant les premier et second intervalles de temps, et la tension sur la seconde ligne de bit (44) étant maintenue au niveau haut durant les premier et second intervalles de temps.

4. Procédé selon la revendication 2, la tension sur la première ligne de bit (8) étant maintenue au niveau haut durant les premier et second intervalles de temps, et la tension sur la seconde ligne de bit (44) étant maintenue au niveau bas durant les premier et second intervalles de temps.
